# EUROPÄISCHE PATENTSCHRIFT

(11) **EP 0 645 060 B1**
(45) Veröffentlichungstag und Bekanntmachung des Hinweises auf die Patenterteilung: **02.09.1998**
(21) Anmeldenummer: 94906830.8
(22) Anmeldetag: 04.02.1994
(51) Int. Cl.: H03K 5/153, H03K 5/08, G01D 5/244, F02P 7/067

(54) **EINRICHTUNG ZUR SIGNALFORMUNG UND ZUR BEZUGSMARKENERKENNUNG**
DEVICE FOR SIGNAL SHAPING AND FOR REFERENCE MARK RECOGNITION
DISPOSITIF PERMETTANT DE FORMER DES SIGNAUX ET D'IDENTIFIER DES REPERES DE REFERENCE

(30) Priorität: 04.02.1993 DE 4303209
(43) Veröffentlichungstag der Anmeldung: 29.03.1995
(73) Patentinhaber: ROBERT BOSCH GMBH, 70442 Stuttgart (DE)
(72) Erfinder: KRAUTER, Immanuel, D-71576 Burgstetten (DE); BURO, Davide, D-72762 Reutlingen (DE)
(86) Internationale Anmeldenummer: DE9400108
(87) Internationale Veröffentlichungsnummer: WO9418754

(56) Entgegenhaltungen:
- EP-A- 0 117 789
- EP-A- 0 366 619
- FR-A- 2 189 987
- GB-A- 2 065 310

## Beschreibung

### Stand der Technik

Die Erfindung geht aus von einer Einrichtung zur Signalformung und zur Bezugsmarkenerkennung nach der Gattung des Hauptanspruchs, bei der aus einem sinusförmigen Signal mit einer Singularität ein Rechtecksignal gebildet wird und die Singularität eindeutig erkannt wird.

Es ist bekannt, daß zur Auswertung eines sinusförmigen Signales dieses zunächst in ein rechteckförmiges Signal umgewandelt werden muß, damit eine einfachere Auswertung möglich ist. Solche sinusförmige Signale treten beispielsweise als Ausgangssignale von Induktivsensoren auf, die sich an ihnen vorüberbewegende Teile mit verschiedenen Markierungen abtasten.

Insbesondere im Zusammenhang mit der Erkennung der Stellung der Kurbel- oder der Nockenwelle einer Brennkraftmaschine werden Geberscheiben, die mit einer dieser Wellen verbunden sind und Anzahl von Markierungen aufweisen, von Induktivsensoren abgetastet und das dabei erhaltene Ausgangssignal im Steuergerät des Kraftfahrzeuges ausgewertet. Vor der Auswertung wird dabei das Ausgangssignal des Induktivsensors in ein Rechtecksignal gewandelt, wobei dazu das sinusförmige Signal mit einem Schwellwert verglichen wird und jeweils beim Überschreiten dieses Schwellwertes ein Flankenwechsel des Rechtecksignales auftritt. Eine solche Anordnung ist beispielsweise aus der DE-OS 31 27 220 bekannt.

Bei dieser bekannten Einrichtung ist es erforderlich, den Schwellwert in Abhängigkeit von der zu erwartenden Signalhöhe zu verändern, da die Höhe des Ausgangssignales des Induktivgebers stark von der Geschwindigkeit der vorbeilaufenden Markierungen abhängt und ein fester Schwellwert daher eine zu große Ungenauigkeit verursachen würde.

Eine weitere Einrichtung zur Signal formung und zur Bezugsmarkenerkennung ist aus der GB-A 20 65 310 bekannt. Bei dieser bekannten Einrichtung wird eine rotierende Scheibe, die an ihrer Oberfläche eine Vielzahl von Winkelmarken aufweist sowie eine durch eine fehlende Winkelmarke gebildete Bezugsmarke bzw. Singularität, von einem feststehenden Induktivsensor abgetastet. Dessen Ausgangssignal wird nach der Verstärkung mit Hilfe einer Schwellwertstufe in ein Signal mit rechteckförmigen Impulsen gewandelt. Zur Ausmessung der Pulsabstände wird ein Abwärtszähler eingesetzt, dessen Zählerstand nur bei der Singularität aufgrund des dann gegebenen größeren Impulsabstandes kleiner als 0 wird. Das Erreichen des Zählerstandes 0 wird dann zur Erkennung der Bezugsmarke bzw. Singularität ausgenutzt.

Aus der Druckschrift FR-A 21 89 987 ist eine Impulsdiskriminatorschaltung bekannt, bei der aus einem Wechselspannungssignal ein Rechtecksignal gebildet wird. Als genauer Umschaltpunkt wird jeweils der Nulldurchgang gewählt. Damit Störsignale nicht zu einer Fehltriggerung führen können, ist eine Diskriminatorschaltung vorgesehen, die eine Umschaltung im Nulldurchgang nur dann zuläßt, wenn zuvor ein negativer Signalpegel von vorgebbarer Größe erreicht wird.

Die EP-A1 0 117 789 zeigt eine weitere Auswerteschaltung, mit der aus einem Wechselspannungssignal ein Rechtecksignal gebildet werden soll. Dabei wird ebenfalls der Nulldurchgang des Wechselspannungssignals als Umschaltbedingung ausgewählt. Ein Umschalten wird jedoch nur zugelassen, wenn der zuvor erreichte positive Signalanteil einen vorgebbaren positiven Schwellwert erreicht hat.

### Vorteile der Erfindung

Gemäß der Erfindung wird eine Einrichtung mit den Merkmalen des Anspruchs 1 vorgeschlagen.

Die erfindungsgemäße Einrichtung mit den kennzeichnenden Merkmalen des Hauptanspruchs hat den Vorteil, daß eine sehr genaue Umwandlung des sinusförmigen Signales in ein Rechtecksignal stattfindet, daß Störungen weitgehend unterdrückt werden und daß die von einer Bezugsmarke verursachte Singularität des sinusförmigen Signales besonders sicher erkannt werden kann und die Rechtecksignalbildung auch im Bereich der Singularität an der richtigen Stelle erfolgt.

Erzielt wird dieser Vorteil, indem der Nulldurchgang des sinusförmigen Signales zur Bildung der Umschaltflanken des Rechtecksignales bzw. zum Pegelwechsel herangezogen wird und die Richtung des Signalnulldurchgangs erkannt wird, bzw. geprüft wird, ob sich der Aufnehmer bei einem Nulldurchgang gegenüber einer Winkelmarke oder einer Lücke befindet. Zur Kontrolle wird die negative Halbwelle zusätzlich auf Unterschreiten eines Schwellwertes überwacht, wobei die bedingte Freigabe der logischen Signale eine Störimpulsspitzen- bzw. Rauschunterdrückung ermöglicht.

Zur eindeutigen Idenfikation der Singularität des sinusförmigen Signales werden vorzugsweise die Abstände zwischen Umschaltflanken bestimmt, wobei die der Singularität folgende fallende Flanke des Rechtecksignales zur Synchronisation dient.

Die zur erfindungsgemäßen Einrichtung gehörende Schaltungsanordnung hat den Vorteil, daß sie einfach aufgebaut ist und in vorteilhafter Weise in C-MOS-Technik integrierbar und damit anwendungsspezifisch einsetzbar. Die lineare Verarbeitung des Eingangssignales in weitem Bereich und der weite Frequenzgang sind ebenfalls vorteilhaft.

Besonders vorteilhaft ist, daß der externe Aufwand zwischen dem Sensor und der erwähnten Schaltungsanordnung auf ein Minimum reduziert wird, so daß lediglich ein Vorwiderstand zwischen dem Sensor und der erfindungsgemäßen Schaltungsanordnung erforderlich ist.

Weitere Vorteile der Erfindung werden durch die in den Unteransprüchen angegebenen Maßnahmen erzielt.

### Zeichnung

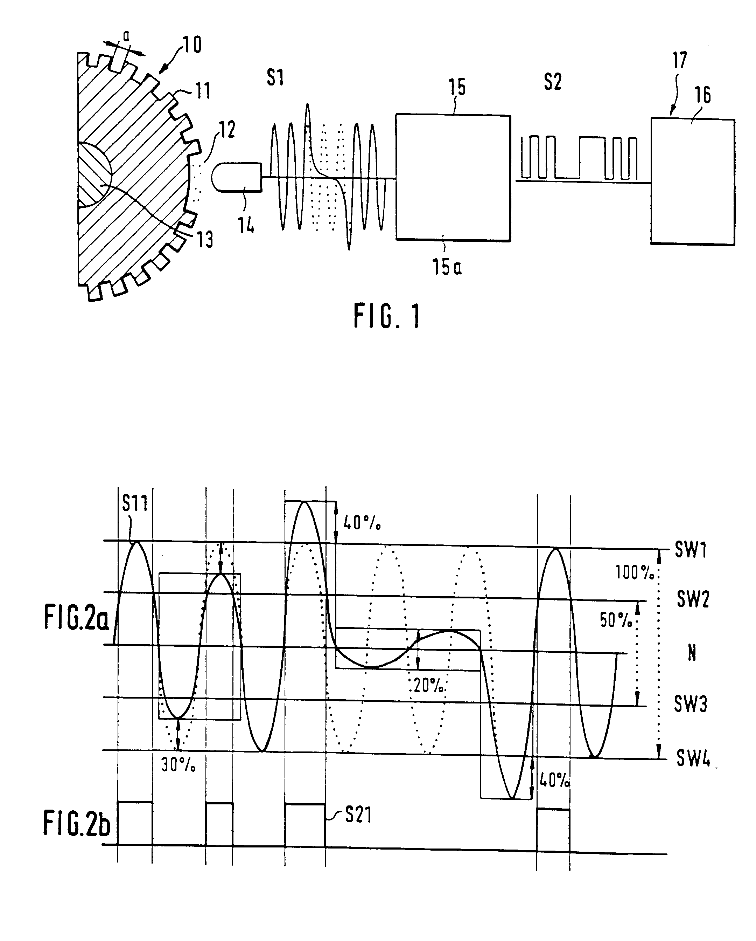

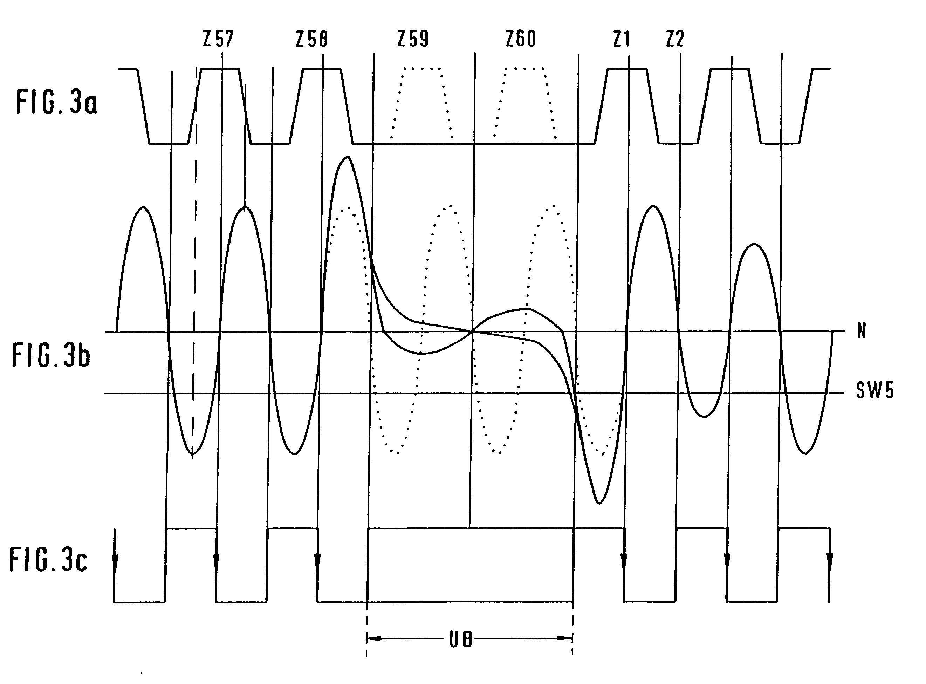

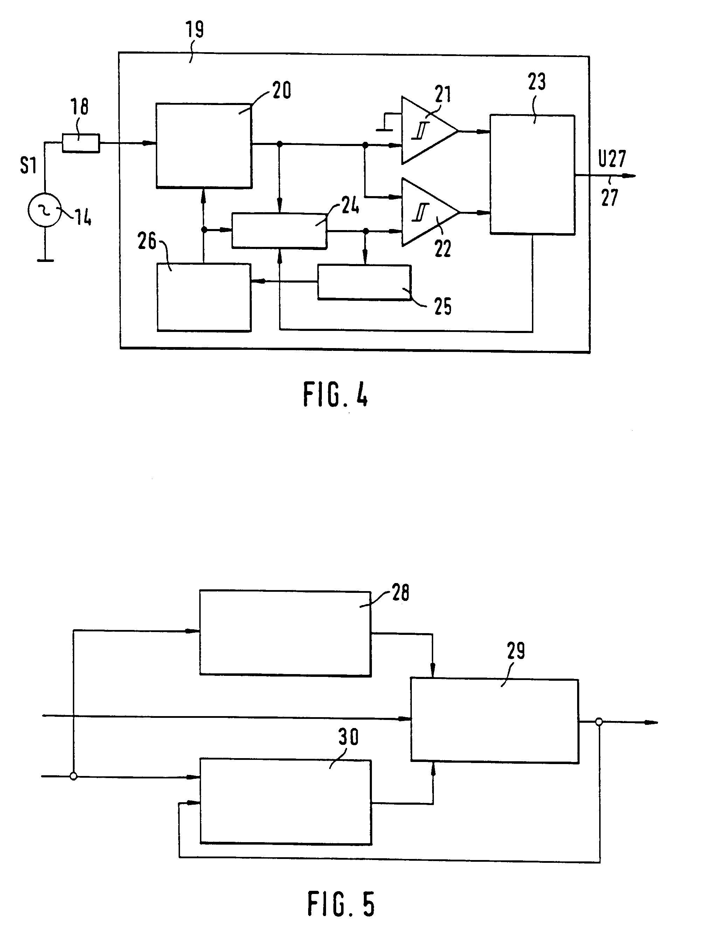

Ein Ausführungsbeispiel der Erfindung ist in der Zeichnung dargestellt und wird in der nachfolgenden Beschreibung näher erläutert. Im einzelnen zeigt Figur 1 eine erfindungsgemäße Einrichtung, in Figur 2 sind Signalverläufe dargestellt, wie sie erhalten werden, wenn die Pegelwechsel des Rechtecksignales bei Überschreiten eines Schwellwertes auftreten. In Figur 3 ist der Signalverlauf angegeben, der mit der erfindungsgemäßen Schaltungsanordnung nach Figur 4 erhalten wird und in Figur 5 ist ein Blockschaltbild der Signalfreigabe- und Lückenaufbereitungslogik, die bereits in Figur 4 als Block angegeben ist, verdeutlicht.

### Beschreibung des Ausführungsbeispieles

Figur 1 zeigt schematisch eine erfindungsgemäße Einrichtung mit dem gewünschten Signalverlauf. Dabei ist mit 10 eine Geberscheibe dargestellt, die an ihrer Oberfläche eine Vielzahl gleichartiger Winkelmarken 11 aufweist sowie einen Bereich, der als Bezugsmarke 12 bezeichnet wird und durch zwei fehlende Winkelmarken charakterisiert wird.

Die Geberscheibe 10 ist fest mit einer rotierenden Welle 13, beispielsweise der Kurbel- oder Nockenwelle einer Brennkraftmaschine oder einer beliebigen anderen drehbaren Welle verbunden. Abgetastet wird die Geberscheibe 10 von einem Aufnehmer 14, beispielsweise einem Induktivsensor.

Beim Vorbeilaufen der Markierungen am Aufnehmer 14 erzeugt der Aufnehmer 14 in bekannter Weise ein sinusförmiges Ausgangssignal, das mit S1 bezeichnet ist. Dieses sinusförmige Signal S1 schwankt regelmäßig um eine Nullinie und weist an der Stelle, die dem Vorbeilaufen der Bezugsmarke 12 am Aufnehmer 14 entspricht, eine Singularität auf. Diese Singularität ist unter anderem dadurch charakterisiert, daß ein erster höherer Impuls auftritt, daß anschließend zwei reguläre positive und zwei reguläre negative Impulse fehlen und anschließend ein vergrößerter negativer Impuls entsteht.

Das Signal S1 wird in einer Aufbereitungsschaltung 15 so verarbeitet, daß ein rechteckförmiges Signal S2 entsteht, mit positiven Impulsen, die eine eindeutige Zuordnung zu den Pulsen des Signales S1 aufweisen. Die exakte Zuordnung ist Figur 3 zu entnehmen.

Das rechteckförmige Signal S2, das als digitale Abbildung des Signales S1 angesehen werden kann, dient als Eingangssignal für eine Winkeluhr 16, die beispielsweise Bestandteil eines Steuergerätes 17 eines Kraftfahrzeuges ist.

Die Aufbereitungsschaltung 15 umfaßt wenigstens einen Verstärker, in dem das sinusförmige Signal in geeigneter Weise verstärkt wird. Diese Verstärkung ist notwendig, da die Höhe der vom Aufnehmer 14 gelieferten Signale stark von der Geschwindigkeit der vorbeilaufenden Marken 11 bzw. von der Drehzahl der Welle 13 abhängt.

Zusätzlich umfaßt die Aufbereitungsschaltung 15 Mittel, mit deren Hilfe die Synchronisationslücke bzw. die Bezugsmarke 12 erkennbar ist. Die Ausgangsimpulse der Aufbereitungsschaltung 15 sollen weder durch das Eingangs rauschen noch durch Leitungsnachschwingungen oder Störungen im Luftspalt gestört sein.

In Figur 2 sind Signalverläufe dargestellt, wie mit bekannten Anordnungen erhalten werden. Gleichzeitig sind die Probleme die bei einer derartigen Auswertung auftreten, erkennbar.

In Figur 2a ist der dem Signal S1 entsprechende Signalverlauf S11, der um die Nullinie N schwankt, vergrößert aufgetragen, gleichzeitig sind positive und negative Schwellwerte, die 50% oder 100% der Signalhöhe entsprechen eingetragen. Die genaue Signalanalyse zeigt, daß die regulären Pulse alle Maximal- (SW1) bzw. Minimalwerte (SW4) von 100% aufweisen und daß vor der Bezugsmarke Überschwinger bis zu 40% höherer Amplitude auftreten, während nach der Bezugsmarke Unterschwinger mit bis zu 40% vergrößerter Amplitude (betragsmäßig) auftreten.

Durch weiterreichende Beeinflussungen der Bezugsmarke sind auch Modulationen der Amplituden der vorhergehenden bzw. nachfolgenden Pulse um bis zu 30% möglich, während dem Auftreten der Bezugsmarke können Störungen auftreten, die beim Beispiel nach Figur 2a bis 20% betragen können.

Bei der Bildung des in Figur 2b dargestellten Rechtecksignales S21, bei dem Flankenwechsel jeweils bei 50 % der Signalhöhe (SW2, SW3) des sinusförmigen Signales erfolgen, treten infolge der ungleich hohen Pulse des Signales S11 nach Figur 2a Ungenauigkeiten auf, die unterschiedliche Breiten der Rechteckimpulse nach Figur 2b verursachen. Diese unterschiedlichen Breiten sollen mit der erfindungsgemäßen Einrichtung vermieden werden.

Die Rechteckimpulse nach Figur 2b, die den Nachteil haben, daß das Puls zur Pause-Verhältnis nicht symmetrisch ist und stark von der Modulation auf dem sinusförmigen Signal beeinflußt wird, verhindern eine genaue Synchronisation einer nachfolgenden Winkeluhr, in der die Rechteckimpulse ausgewertet werden sollen. Mit einer Einrichtung nach Figur 4 bzw. 5, deren Funktionsweisen nun mit Hilfe der in Figur 3 aufgetragenen Signalverläufe erläutert werden soll, lassen sich die angesprochenen Probleme vermeiden.

In Figur 3a sind die Winkelmarken einer derzeit schon im Einsatz befindlichen Kurbelwellenscheibe dargestellt. Diese Geberscheiben weisen heute 60-2 Winkelmarken bzw. Zähne (Z1 bis Z60) auf, die fehlenden Winkelmarken 59 und 60 bilden die Bezugsmarke. Die Erfindung beschränkt sich jedoch nicht auf dieses Beispiel, sondern ist für beliebige Körper mit regular geformter Oberfläche und wenigstens einer Singularität einsetzbar.

Beim Vorbeilaufen einer Geberscheibe mit einer Winkelmarkenanordnung nach Figur 3a an einem Induktivaufnehmer werden in diesem sinusförmige Signale erzeugt wie sie in Figur 3b dargestellt sind. Dabei entspricht ein Nulldurchgang (N) des Signales jeweils einer Marken- oder einer Lückenmitte.

Vor und nach der Bezugsmarke, deren Vorbeilauf am Aufnehmer eine Singularität verursacht, treten wiederum Überschwinger auf, während des Vorbeilaufens der Bezugsmarke vor dem Aufnehmer können Störimpulse auftreten. Erkennt nun eine Auswerteschaltung im Nulldurchgang des Signales 3b ob sich der Sensor auf einen Zahn oder einer Zahnlücke befindet bzw. erkennt die Schaltungsanordnung ob ein Übergang von positivem zu negativem oder von negativem zu positivem Pegel vorliegt, lassen sich eindeutige Signalwechsel für das Signal nach Figur 3c definieren.

Wird nun bei jeder negativen Halbwelle zusätzlich untersucht, ob es sich tatsächlich um eine Marke oder nur um eine Störung handelt, ist eine zuverlässigere Signalformung möglich, die auch eine zuverlässige Bezugsmarkenerkennung ermöglicht. Als Kriterium dafür, daß es sich um eine Marke und nicht um eine Störung handelt, wird überprüft, ob die nächste negative Halbwelle einen bestimmten Schwellwert, beispielsweise 50% des vorherigen Spitzenwertes der Signalamplitude unterschreitet.

Da die Umschaltung der Polarität der rechteckförmigen Ausgangsimpulse immer beim Nulldurchgang des Eingangssignales, sowohl beim Nulldurchgang von positiver nach negativer als auch von negativer zu positiver Seite stattfindet, ist das Puls-Pause-Verhältnis unabhängig von der Modulation nahezu identisch.

Solange die Bezugsmarke am Aufnehmer vorbeiläuft, solange also keine regelmäßigen Signalpulse des Sensorausgangssignales auftreten, findet im rechteckförmigen Ausgangssignal genau ein Übergang von low zu high bzw. von Null zu Eins statt. Da dieses Signal im Nulldurchgang des Sensorsignales schaltet, hängt die Lage in der Bezugsmarkenlücke von der Lage des ersten Nulldurchgangs nach dem Auftreten der letzten Markierung ab. Dieser Nulldurchgang hängt wiederum davon ab, ob und welche Störung während der Bezugsmarkenlücke aufgetreten ist. Weiterhin hängt die Lage des ersten Nulldurchgangs davon ab, welche Nachschwingeigenschaft das Sensor-Leitungs-System aufweist.

Bei dem in Figur 3a dargestellten System findet der Nulldurchgang frühestens als Nachschwingung der 58. Markierung (Z58) und spätestens als Reaktion auf die erste darauffolgende Markierung statt. Innerhalb dieses Bereiches ergibt sich ein Unsicherheitsbereich UB für die nächste positive Flanke. Es kann dabei entweder eine lange Pause und anschließend ein kurzer Impuls auftreten oder eine kurze Pause und ein langer Impuls. Ist die Länge der Markierungen gleich ihrem Abstand, sind Impulse und Impulspausen gleich lang.

Die Länge der Impulse bzw. Impulspausen bzw. der Abstand zwischen wählbaren Impulsflanken kann z.B. in einer nachgeschalteten Winkeluhr oder einer beliebigen Zeit- oder Winkelmeßeinrichtung zur Erkennung der Bezugsmarkenlücke ausgewertet werden, da die Bezugsmarkenlücke einen signifikant größeren Wert aufweist als die Abstände zwischen den übrigen Winkelmarken. Eine Synchronisation kann dann bei der ersten fallenden Flanke des Rechtecksignales nach Figur 3c nach der erkannten Bezugs- markenlücke stattfinden.

In Figur 4 ist ein Blockschaltbild einer erfindungsgemäßen Auswerteschaltung dargestellt. Der Aufnehmer ist dabei wiederum mit 14 bezeichnet, er ist über einen Vorwiderstand 18 mit der sogenannten internen Schaltung 19 verbunden. Diese interne Schaltung 19 besteht aus einem einstellbaren Strom/Spannungswandler mit Halbwellengleichrichter 20, aus zwei Komparatoren 21, 22, einer Logik für die Signalfreigabe und Lückenaufbereitung 23, einem Spitzenweggleichrichter 24, einer Spannungsüberwachung 25 und einer Verstärkungsanpassung 26. Am Ausgang 27 entsteht das digitale Ausgangssignal, das dem Signal S2 der Figur 1 entspricht. In der Lückenaufbereitung wird die beim Ausführungsbeispiel als Lücke ausgebildete Bezugsmarke erkannt.

Das Signal S1, das vom Sensor 14 geliefert wird, wird über den Vorwiderstand 18, in dem die teilweise sehr hohe Ausgangsspannung des Sensors in einen Strom umgewandelt wird, der internen Schaltung 19 zugeführt. Dieser Strom fließt in den virtuellen Massepunkt eines als einstellbarer Strom/Spannungswandler geschalteten invertierenden Operationsverstärkers und Halbwellengleichrichters.

Am Ausgang dieses einstellbaren Strom/Spannungswandlers mit Halbwellengleichrichter 20 entsteht eine lineare Abbildung des negativen Sensorsignales. Dieses Signal wird im Spitzenweggleichrichter 24 gleichgerichtet und gespeichert. Wird dieses Signal zu groß oder zu klein, dann erfolgt ausgelöst durch die Spannungsüberwachung 25 in der Verstärkungsanpassung 26 eine entsprechende Anpassung des Strom/Spannungswandlers und der Abgleich des im Spitzenweggleichrichter 24 gespeicherten Spitzenwertes.

Die Logik für die Signalfreigabe und Lückenaufbereitung 23 bildet zusammen mit den beiden Komparatoren 21 und 22 den eigentlichen Kern des erfindungsgemäßen Schaltungskonzeptes. Diese Logik 23 ist in Figur 5 näher dargestellt. Dabei bezeichnet der Block 28 einen Up/Down-Zähler 28, ein RS-Flipflop 29 sowie ein RS-Flipflop 30.

Der Komparator 21 zeigt an, ob das Sensorsignal positiv oder negativ ist. Der Komparator 22 erkennt, ob das Sensorsignal 50% der letzten Pulsamplituden erreicht hat. Diese beiden Informationen werden an die Logik für die Signalfreigabe und Lückenaufbereitung 23 weitergegeben.

Dabei gelangt das Ausgangssignal des Komparators 22 sowohl zum Up/Down Zähler 28 als auch zum RS-Flipflop 30. Das Ausgangssignal des Komparators 21, das einen Null Durchgang erkennen läßt, gelangt nur zum RS-Flipflop 29, dessen Ausgangssignal auf einen zweiten Eingang des RS-Flipflops 30 gelangt.

Mit Hilfe der beiden von den Komparatoren 21 und 22 gelieferten Signalen führt die Freigabelogik die Weiterverarbeitung und Aufbereitung des Signales und der Bezugsmarkenlücke durch. Dabei ermöglichen der Up-Down-Zähler 28 eine Freigabe für einen High-Impuls bzw. für eine logische 1. Das RS-Flipflop 30 bewirkt eine Freigabe des Low-Impulses bzw. einer logischen Null. Die Freigabesignale werden im RS-Flipflop 29 weiterverarbeitet, die bedingte Freigabe der logischen Signale Null oder 1 ermöglichen eine Störimpulsspitzen- bzw. Rauschunterdrückung.

Der Up/Down Zähler 28 sowie die Flip-Flop 29, 30 können durch geeignete rechnerinterne Mittel im Steuergerät realisiert sein.

## Patentansprüche

1. Einrichtung zur Bildung eines rechteckförmigen Signales (S2) und zur eindeutigen Erkennung einer Singularität aus einem sinusförmigen Signal (S1) mit positiven und negativen Halbwellen und einer Singularität, mit einer Aufbereitungsschaltung (15), der das sinusförmige Signal (S1) zugeführt wird, wobei die Aufbereitungsschaltung (15) eine Logik (23) für eine Signalfreigabe und eine Singularitätenaufbereitung umfaßt, wobei die Logik einen Zähler umfaßt, dadurch gekennzeichnet, daß die Aufbereitungsschaltung (15) einen ersten Komparator (21), dessen Ausgangssignal einen Nulldurchgang erkennen läßt, und einen zweiten Komparator (22), der erkennt, ob das sinusförmige Signal (S1) einen vorgebbaren Schwellwert (SW5) unterschritten hat umfaßt, wobei die Logik (23) einen Up/Downzähler (28), dessen Eingang mit dem Ausgang des zweiten Komparators (22) verbunden ist und dessen Ausgang auf einen ersten Eingang eines RS-Flipflops (29) führt, das über einen zweiten Eingang mit dem Ausgang des ersten Komparators (21) verbunden ist, und ein RS-Flipflop (30), dessen Eingang mit dem Ausgang des zweiten Komparators (22) verbunden ist, dessen Ausgang auf einen weiteren Eingang des RS-Flipflops (29) führt und dessen anderer Eingang mit dem Ausgang des RS-Flipflops (29) verbunden ist, umfaßt, und wobei die Aufbereitungsschaltung (15) jeweils beim Nulldurchgang (N) des sinusförmigen Signales (S1) überprüft, ob entweder ein Übergang von positivem zu negativem oder von negativem zu positivem Pegel vorliegt, dabei, sofern am Ausgang des Up/Down-Zählers (28) eine Freigabe für einen High-Impuls anliegt, jeweils beim Übergang von positivem zu negativem Pegel des sinusförmigen Signals (S1) einen Pegelwechsel des rechteckförmigen Signales (S2) in eine erste Richtung bewirkt und, sofern gemäß der zusätzlichen Überprüfung des sinusförmigen Signales (S1) in der Aufbereitungsschaltung (15) die letzte negative Halbwelle des sinusförmigen Signales (S1) den vorgebbaren Schwellwert (SW5) unterschritten hat, jeweils beim Übergang von negativem zu positivem Pegel des sinusförmigen Signals (S1) einen Pegelwechsel des rechteckförmigen Signales (S2) in die andere Richtung bewirkt, wobei der vorgebbare Schwellwert (S5) in Abhängigkeit vom vorherigen Spitzenwert des sinusförmigen Signales (S1) festgelegt ist.

2. Einrichtung nach Anspruch 1, dadurch gekennzeichnet, daß der Schwellwert (SW5) 50% des vorherigen Maximums beträgt.

3. Einrichtung nach Anspruch 1 oder 2, dadurch gekennzeichnet, daß die Singularität erkannbar ist, indem die Dauer zwischen vorgebbaren Signalflanken des rechteckförmigen Signales (S2) bestimmt wird und die Singularität erkannt wird, wenn diese Dauer einen signifikant größeren Wert aufweist als die übrigen Abstände.

4. System, umfassend eine Einrichtung nach Anspruch 3, einen Magnetsensor (14) und ein abzutastendes Teil (10), wobei die Einrichtung zur Auswertung des Ausgangssignales des Magnetsensors eingesetzt wird, der das mit einer Anzahl gleichartiger Markierungen (11) und wenigstens einer fehlenden Markierung (12) rotierende Teil (10) abtastet, wobei das rotierende Teil eine Singularität aufweist, die durch den Bereich der fehlenden Markierung (12) verursacht wird und die Singularität des rotierenden Teiles (10) eine Bezugsmarke kennzeichnet.

5. System nach Anspruch 4, dadurch gekennzeichnet, daß das rotierende Teil eine mit einer Welle, beispielsweise der Kurbel- oder Nockenwelle einer Brennkraftmaschine, verbundene Geberscheibe ist.

6. System nach Anspruch 4 oder 5, dadurch gekennzeichnet, daß die Aufbereitungsschaltung (15) einen Vorwiderstand (18) umfaßt, über den das Signal des Magnetsensors zugeführt wird und daß am Ausgang der Aufbereitungsschaltung (15) das zu bildende digitale Ausgangssignal entsteht.

## Claims

1. Device for shaping a square-wave signal (S2) and for unambiguous recognition of a singularity from a sinusoidal signal (S1) with positive and negative halfwaves and a singularity, having a conditioning circuit (15) to which the sinusoidal signal (S1) is fed, the conditioning circuit (15) comprising a logic device (23) for signal release and a singularity conditioning device, the logic device comprising a counter, characterized in that the conditioning circuit (15) comprises a first comparator (21), whose output signal enables a zero crossover to be detected, and a second comparator (22), which detects whether the sinusoidal signal (S1) has dropped below a prescribable threshold value (SW5), the logic device (23) comprising an up/down counter (28) whose input is connected to the output of the second comparator (22) and whose output leads to a first input of an RS flip-flop (29) which is connected via a second input to the output of the first comparator (21), and an RS flip-flop (30) whose input is connected to the output of the second comparator (22), whose output leads to a further input of the RS flip-flop (29) and whose other input is connected to the output of the RS flip-flop (29), and the conditioning circuit (15) checking, in each case at the zero crossover (N) of the sinusoidal signal (S1), whether there is either a change-over from a positive level to a negative level or from a negative level to a positive level, and in doing so bringing about, in each case at the change-over from the positive to the negative level of the sinusoidal signal (S1) a level change of the square-wave signal (S2) in a first direction, provided a release for a high pulse is present at the output of the up/down counter (28), and bringing about, in each case at the change-over from the negative level to the positive level of the sinusoidal signal (S1), a level change of the square-wave signal (S2) in the other direction, provided, according to the additional checking of the sinusoidal signal (S1) in the conditioning circuit (15), the last negative halfwave of the sinusoidal signal (S1) has dropped below the prescribable threshold value (SW5), the prescribable threshold value (S5) being defined as a function of the previous peak value of the sinusoidal signal (S1).

2. Device according to Claim 1, characterized in that the threshold value (SW5)is 50% of the previous maximum.

3. Device according to Claim 1 or 2, characterized in that the singularity can be detected by determining the duration between prescribable signal edges of the square-wave signal (S2), and the singularity is detected if this duration has a significantly greater value than the other intervals.

4. System comprising a device according to Claim 3, a magnetic sensor (14) and an element (10) which is to be sensed, the device being used to evaluate the output signal of the magnetic sensor which senses the element (10) which rotates with a number of identical marks (11) and at least one absent mark (12), the rotating element having a singularity which is brought about by the region of the absent mark (12) and a singularity characterizes the reference mark of the rotating element (10).

5. System according to Claim 4, characterized in that the rotating element is a sensor disc which is connected to a shaft, for example the crankshaft or cam shaft of an internal combustion engine.

6. System according to Claim 4 or 5, characterized in that the conditioning circuit (15) has a series resistor (18) via which the signal of the magnetic sensor is fed, and in that the digital output signal to be formed comes about at the output of the conditioning circuit (15).

## Revendications

1. Dispositif servant à former un signal de forme rectangulaire (S2) et à identifier de façon univoque une singularité émanant d'un signal de forme sinusoïdale (S1) avec des demi-ondes positives et négatives, et une singularité, avec un circuit de préparation (15), auquel est amené le signal de forme sinusoïdale (S1), le circuit de préparation (15) comprenant un circuit logique (23) pour libérer les signaux et une préparation des singularités, le circuit logique comprenant un compteur,
caractérisé en ce que
le circuit de préparation (15) comprend un premier comparateur (21), dont le signal de sortie permet d'identifier un passage à zéro, et un deuxième comparateur (22), qui détecte si le signal de forme sinusoïdale (S1) est tombé en dessous d'une valeur de seuil (SNS), que l'on peut définir au préalable, le circuit logique (23) comprenant un compteur montant et descendant (28), dont l'entrée est reliée à la sortie du deuxième comparateur (22), et dont la sortie mène à une première entrée d'une bascule électronique à clé d'appel (29), qui est reliée par une deuxième entrée à la sortie du premier comparateur (21), et une bascule électronique à clé d'appel(30), dont l'entrée est reliée à la sortie du deuxième comparateur (22), dont la sortie mène à une autre entrée de la bascule électronique à clé d'appel (29), et dont l'autre entrée est reliée à la sortie de la bascule électronique à clé d'appel (29), et le circuit de préparation (15) contrôlant lors du passage à zéro (N) du signal de forme sinusoïdale (S1), si il y a soit un passage d'un niveau positif à un niveau négatif, soit d'un niveau négatif à un niveau positif, dans ce cas, pour autant qu'à la sortie du compteur montant et descendant (28) il y a une délivrance d'une impulsion haute, un changement de niveau se produisant dans un premier sens respectivement lors du passage du niveau positif au niveau négatif du signal (S1) de forme sinusoïdale, un changement de niveau du signal de forme rectangulaire (S2) et pour autant que selon le contrôle additionnel du signal de forme sinusoïdale (S1) dans le circuit de préparation (15), la dernière demi-onde négative du signal de forme sinusoïdale (S1) est tombée en dessous de la valeur de seuil (SW5), qui peut être définie au préalable, un changement de niveau du signal de forme rectangulaire (S2) se produisant dans l'autre sens, lors du passage du niveau négatif au niveau positif du signal de forme sinusoïdale (S1), la valeur de seuil (S5), qui peut être définie au préalable étant déterminée en fonction de la valeur de pointe précédente du signal de forme sinusoïdale (S1).

2. Dispositif selon la revendication 1,
caractérisé en ce que
la valeur de seuil (SW5) atteint 50 % du maximum précédent.

3. Dispositif selon la revendication 1 ou 2,
caractérisé en ce que
la singularité peut être identifiée en déterminant la durée qui s'écoule entre des flancs du signal (S2), que l'on peut définir au préalable, et la singularité est identifiée, quand cette durée présente une valeur sensiblement plus grande que celle des autres intervalles.

4. Système comprenant un dispositif selon la revendication 3, un détecteur magnétique (14) et un élément servant à balayer (10), le dispositif étant utilisé pour l'exploitation du signal de sortie du détecteur magnétique, qui balaie les signaux de la pièce tournante (10) avec un certain nombre de repérages de même type (11) et au moins un repérage (12) qui fait défaut, la pièce tournante présentant une singularité qui est causée par la zone du repérage qui fait défaut (12) et la singularité de la pièce tournante (10) caractérisant un repère de référence.

5. Système selon la revendication 4,
caractérisé en ce que
la pièce tournante est un disque de détecteur relié à un arbre, par exemple celui de l'arbre à cames ou du vilebrequin d'un moteur à combustion interne.

6. Système selon la revendication 4 ou 5,
caractérisé en ce que
• le circuit de préparation (15) comprend une résistance série (18), au moyen de laquelle est amené le signal du détecteur magnétique et
• il y a, à la sortie du circuit de préparation (15) le signal numérique de sortie à former.
